# EUROPEAN PATENT APPLICATION

(11) **EP 4 730 639 A1**
(43) Date of publication of application: **22.04.2026**
(21) Application number: 25209427.1
(22) Date of filing: 17.10.2025
(51) Int. Cl.: H02P 6/182, H02P 27/08, H02P 6/10

(54) **DEVICE AND METHOD FOR MEASURING BACK ELECTROMOTIVE FORCE OF MOTOR**

(30) Priority: 18.10.2024 KR 20240142942
(71) Applicant: LX Semicon Co., Ltd., Daejeon 34027 (KR)
(72) Inventor: MIN, Chol, 34027 Daejeon (KR); CHOI, Jong Tae, 34027 Daejeon (KR); HA, Jae Hyun, 34027 Daejeon (KR)
(74) Representative: Goddar, Heinz J.

(57) **Abstract**

The device for measuring a back electromotive force of a motor includes a phase voltage floating part that floats a phase voltage of the motor; a back electromotive force measurement part that measures a back electromotive force corresponding to a pulse signal generated by floating the phase voltage; a back electromotive force range determination part that determines whether the back electromotive force is within a set range, and when the back electromotive force is within the set range, determines whether the back electromotive force is consecutively maintained within the set range for a set number of pulse signals generated by the motor during a floating interval; and a back electromotive force calculation part that calculates an average value from a back electromotive force for each of the set number of pulse signals and determines the average value as a back electromotive force during the floating interval when the back electromotive force is consecutively maintained within the set range for the set number of pulse signals.

## Description

### BACKGROUND

### Field

An embodiment relates to a device and a method for measuring a back electromotive force of a motor.

### Discussion of Related Art

The matters described in the background art section have been prepared to enhance the understanding of the background of the invention, and may include matters that are not prior art well known to those skilled in the art to which this technology belongs.

Recently, in an electronic apparatus including an appliance such as a washing machine or a drying machine, a brushless direct current (BLDC) motor that does not use a brush for rectification to have high energy efficiency is used.

A general method for controlling such a BLDC motor is a feedback control method for performing control such that an output value that is output when the motor is actually driven follows a command value that is input to control motor driving.

The BLDC motor control described above has a sequence of alignment, open loop, close loop, and steady speed driving after motor is driven.

On the other hand, a method for controlling a BLDC motor by measuring a back electromotive force is a method capable of a little simply controlling the BLDC motor because the back electromotive force is directly measured and used; however, when an error occurs in back electromotive force measurement due to the influence of hardware, an error may occur in motor control.

### SUMMARY

An embodiment provides a device and a method for measuring a back electromotive force of a motor capable of stably controlling the motor by eliminating an error that may occur in motor control due to an error in back electromotive force measurement caused by the influence of hardware or noise.

The problems of the present disclosure are not limited to those described above, and other problems not described will be clearly understood by those skilled in the art from the following description.

A device for measuring a back electromotive force of a motor according to an aspect of the present disclosure includes a phase voltage floating part configured to float a phase voltage of the motor; a back electromotive force measurement part configured to measure a back electromotive force corresponding to a pulse signal generated by floating the phase voltage; a back electromotive force range determination part configured to determine whether the back electromotive force is within a set range, and when the back electromotive force is within the set range, to determine whether the back electromotive force is consecutively maintained within the set range with respect to the set number of pulse signals generated by the motor during a floating interval; and a back electromotive force calculation part configured to, when the back electromotive force is consecutively maintained within the set range for the set number of pulse signals, calculate an average value from the back electromotive force for each of the set number of pulse signals, and to determine the average value as a back electromotive force during the floating interval.

The device may further include a floating release part configured to release the floating of the phase voltage of the motor after the average value is calculated from the back electromotive force for each of the set number of pulse signals and determined as the back electromotive force during the floating interval.

The back electromotive force range determination part may determine whether the back electromotive force is outside the set range for all of the set number of pulse signals during the floating interval when the back electromotive force is not within the set range, and the back electromotive force calculation part may not determine a back electromotive force in a corresponding cycle of the phase voltage when the back electromotive force is outside the set range for all of the set number of pulse signals during the floating interval.

When the back electromotive force is not outside the set range, the back electromotive force measurement part may measure the back electromotive force corresponding to the pulse signal generated by floating the phase voltage.

When the back electromotive force is not maintained within the set range, the back electromotive force measurement part may measure the back electromotive force corresponding to the pulse signal generated by floating the phase voltage.

The set range may be 0 + N to VDD - N (where VDD is a motor driving voltage, and N is a set value).

A method for measuring a back electromotive force of a motor according to an aspect of the present disclosure includes, by a phase voltage floating part, floating a phase voltage of the motor; by a back electromotive force measurement part, measuring a back electromotive force corresponding to a pulse signal generated by floating the phase voltage; by a back electromotive force range determination part, determining whether the back electromotive force is within a set range; when the back electromotive force is within the set range, by the back electromotive force range determination part, determining whether the back electromotive force is consecutively maintained within the set range for a set number of pulse signals generated by the motor during a floating interval; and when the back electromotive force is consecutively maintained within the set range for the set number of pulse signals, by a back electromotive force calculation part, calculating an average value from a back electromotive force for each of the set number of pulse signals and determining the average value as a back electromotive force during the floating interval. Any one, some or all of the features of the device disclosed herein may be correspondingly applied also to the method, and vice versa, unless technically inappropriate or indicated otherwise.

The method may further include, by a floating release part, releasing the floating of the phase voltage of the motor after the average value is calculated from the back electromotive force for each of the set number of pulse signals and determined as the back electromotive force during the floating interval.

The method may further include, by the back electromotive force range determination part, determining whether the back electromotive force is outside the set range for all of the set number of pulse signals during the floating interval when the back electromotive force is not within the set range; and by the back electromotive force calculation part, not determining a back electromotive force in a corresponding cycle of the phase voltage when the back electromotive force is outside the set range.

The method may further include, by the back electromotive force measurement part, measuring the back electromotive force corresponding to the pulse signal generated by floating the phase voltage when the back electromotive force is not outside the set range.

The method may further include, by the back electromotive force measurement part, measuring the back electromotive force corresponding to the pulse signal generated by floating the phase voltage when the back electromotive force is not maintained within the set range.

The set range is 0 + N to VDD - N (where VDD is a motor driving voltage, and N is a set value).

According to the embodiment, the motor is stably controlled by eliminating an error that may occur in motor control due to an error in back electromotive force measurement caused by the influence of hardware or noise, and as a result, only a back electromotive force voltage can be actually used for motor control.

The effects of the present disclosure are not limited to the effects described above, and other effects not described will be understood by those skilled in the art from the following description and the appended claims.

### BRIEF DESCRIPTION OF THE DRAWINGS

The above and other objects, features, and advantages of the present disclosure will become more apparent to those of ordinary skill in the art by describing exemplary embodiments thereof in detail with reference to the attached drawings, in which:
FIG. 1 is a configuration diagram of a motor driving device according to an embodiment of the present disclosure;
FIG. 2 is a diagram illustrating a circuit configuration of the motor driving device according to the embodiment of the present disclosure;
FIG. 3 is a configuration diagram specifically illustrating a configuration of the motor driving device according to the embodiment of the present disclosure;
FIG. 4 is a configuration diagram specifically illustrating a configuration of a detector in FIG. 3;
FIGS. 5 and 6 are diagrams illustrating a zero cross delay value of a phase current in contrast to a phase of a phase voltage according to the embodiment of the present disclosure;
FIG. 7 is a graph illustrating a floating region for back electromotive force measurement according to the embodiment of the present disclosure;
FIG. 8 is a graph of a back electromotive force and a U-phase current with respect to a back electromotive force reference voltage according to the embodiment of the present disclosure; and
FIG. 9 is a flowchart illustrating a method for measuring a back electromotive force of a motor according to the embodiment of the present disclosure.

### DETAILED DESCRIPTION OF EXEMPLARY EMBODIMENTS

The advantages and features of the present disclosure, and methods of achieving them will be apparent from the embodiments described below in conjunction with the accompanying drawings. However, the present disclosure is not limited to the embodiments disclosed herein and may be implemented in many different forms. The embodiments are provided to make the disclosure of the present disclosure complete and to allow those skilled in the art to fully understand the scope of the present disclosure, and the present disclosure is defined only within the scope of the appended claims.

The shapes, sizes, proportions, angles, numbers and the like shown in the accompanying drawings for the purpose of illustrating the embodiments of the present disclosure are merely examples, and the present disclosure is not limited thereto. Identical reference numerals designate identical components throughout the description. Further, in describing the present disclosure, detailed descriptions of known related technologies may be omitted if it is considered to unnecessarily obscure the gist of the present disclosure. The terms such as "including," "having," and "consisting of" used herein are generally intended to allow other components to be added unless the terms are used with the term "only." References to components of a singular noun include the plural of that noun, unless specifically stated otherwise.

In the interpretation of components, they are construed to include margins of error, even if not explicitly stated.

When describing a positional relationship, for example, "on," "above," "below," or "next to" describes the positional relationship of two parts, one or more other parts may be located between the two parts, unless "immediately" or "directly" is used.

When describing a temporal contextual relationship is described, for example, such as "after," "following," "next to," or "before," it may also include non-contiguous cases unless "immediately" or "directly" is used.

As used herein, the term "part" may refer to a unit that processes at least one function or operation, such as a software or hardware component. The functions provided by the "part" may be performed separately by multiple components, or it may be integrated with other additional components. In this specification, the "part" may be implemented in a single circuit or in a plurality of circuits, or in a single device or in a plurality of devices.

Each of the features of various embodiments described herein may be coupled or combined with one another in whole or in part, and may be technologically interlocked and operated in various ways, and each of the embodiments may be carried out independently or in conjunction with one another.

Hereinafter, various embodiments of the present disclosure will be described in detail with reference to the accompanying drawings.

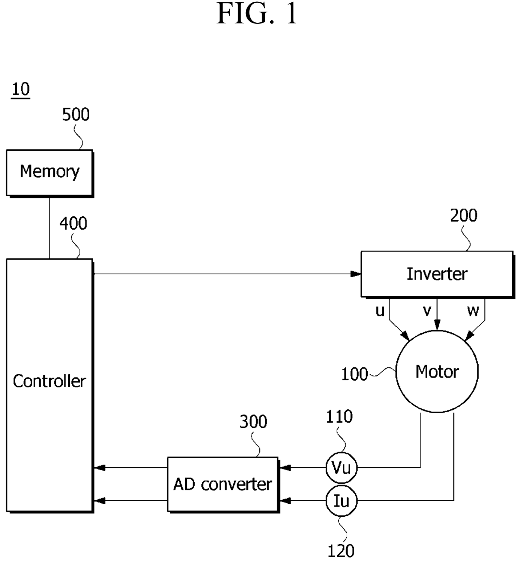

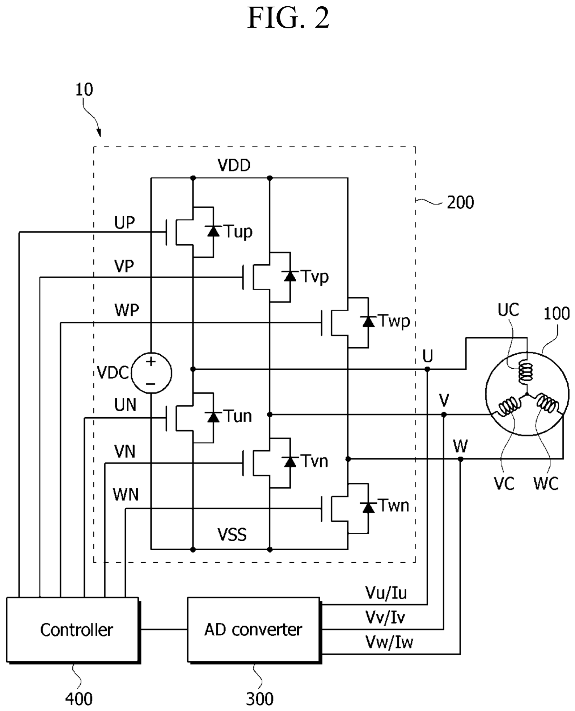

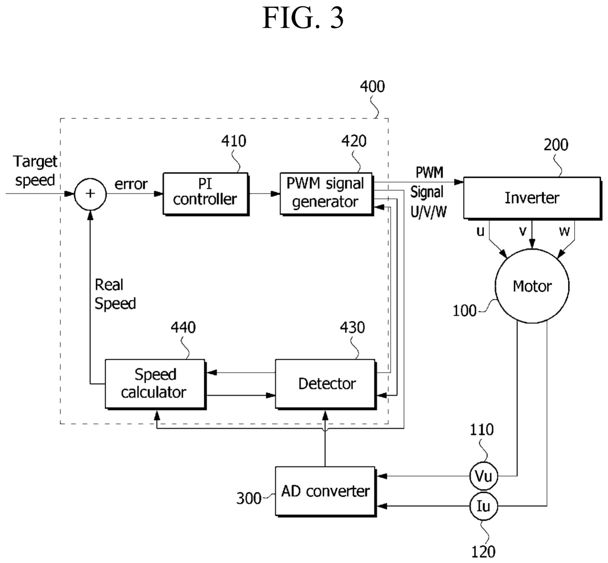

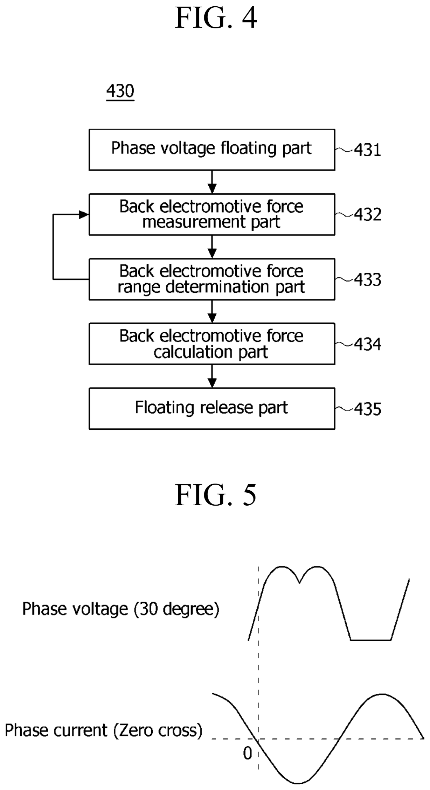

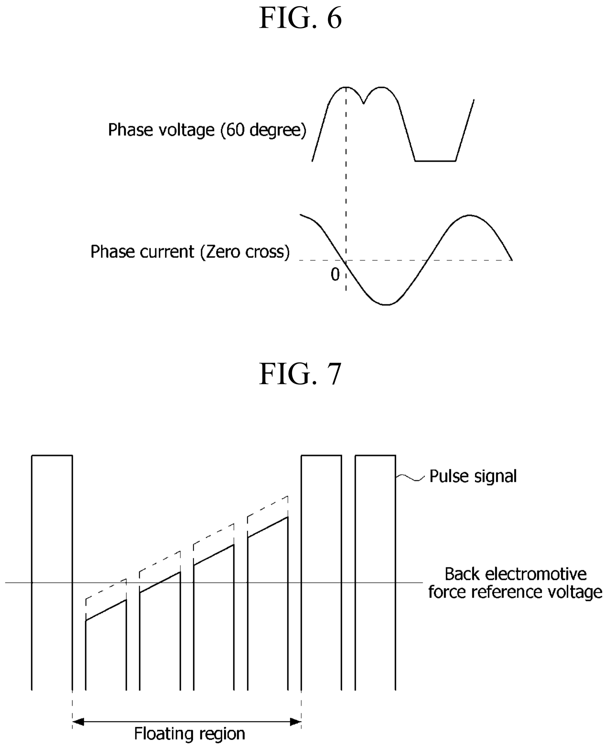

FIG. 1 is a configuration diagram of a motor driving device according to an embodiment of the present disclosure. FIG. 2 is a diagram illustrating a circuit configuration of the motor driving device according to the embodiment of the present disclosure. FIG. 3 is a configuration diagram specifically illustrating a configuration of the motor driving device according to the embodiment of the present disclosure. FIG. 4 is a diagram illustrating a configuration of a detector according to the embodiment of the present disclosure. FIGS. 5 and 6 are diagrams illustrating a zero cross delay value of a phase current in contrast to a phase of a phase voltage according to the embodiment of the present disclosure.

Referring to FIG. 1, a motor driving device 10 may include driving circuit blocks 200, 300, 400, and 500 for driving a motor 100. As an example, the motor driving device 10 may drive a sensor-less BLDC motor 100.

The motor driving device 10 may include an inverter 200 that transfers a driving voltage to the motor 100, a voltage sensor 110 that senses a phase voltage Vu output from the motor 100, a current sensor 120 that senses a phase current Iu output from the motor 100, and a controller 400 that controls the inverter 200 to drive the motor 100.

In the embodiment, for convenience of description, a case where the voltage sensor 110 senses a U-phase phase voltage, and the current sensor 120 senses a U-phase phase current will be described; however, the embodiment is not limited thereto, the voltage sensor 110 and the current sensor 120 may sensor a V-phase or W-phase phase voltage and phase current. The voltage sensor 110 and the current sensor 120 may be simply expressed as sensors 110 and 120.

A memory 500 may be connected to the controller 400. The memory 500 may be provided outside the controller 400. The memory 500 may be embedded in a semiconductor chip such as a micro controller unit (MCU) or a motor driver IC along with the controller 400. The motor driving device 10 may be an MCU or a motor driver IC.

The memory 500 may be implemented as an electrically erasable and programmable read only memory (EEPROM).

In the embodiment, the motor 100 may include a stator including a three-phase coil UC, VC, and WC with different phases and a rotor using a permanent magnet as in FIG. 2.

The stator of the motor 100 may include a first coil UC having a U-phase, a second coil VC having a V-phase, and a third coil WC having a W-phase. The motor 100 may be driven according to the driving voltage supplied from the inverter 200 to each coil of the three-phase coil UC, VC, and WC. In this case, magnetic forces generated by the first to third coils UC, VC, and WC may rotate the rotor of the motor 100.

The inverter 200 generates the driving voltage according to a PWM signal for controlling the driving of the motor 100 and supplies the driving voltage to the motor 100.

Specifically, the inverter 200 may supply a first driving voltage VDD or may supply a second driving voltage VSS to the three-phase coil UC, VC, and WC of the motor 100 via first to third phases U, V, and W under the control of the controller 400. The inverter 200 may float the coil without supplying the first and second driving voltages VDD and VSS.

The inverter 200 receives the first driving voltage VDD and the second driving voltage from a power supply VDC. The inverter 200 may receive first-first and first-second and first-second pulse width modulation (PWM) signals UP and UN, second-first and second-second PWM signals VP and VN, and third-first and third-second PWM signals WP and WN from the controller 400.

The inverter 200 may include a first pull-up transistor Tup and a first pull-down transistor Tun connected in series between a supply line of the first driving voltage VDD and a supply line of the second driving voltage VSS for driving the first coil UC of the motor 100.

The inverter 200 may include a second pull-up transistor Tvp and a second pull-down transistor Tvn connected in series between the supply line of the first driving voltage VDD and the supply line of the second driving voltage VSS for driving the second coil VC of the motor 100.

The inverter 200 may include a third pull-up transistor Twp and a third pull-down transistor Twn connected in series between the supply line of the first driving voltage VDD and the supply line of the second driving voltage VSS for driving the third coil WC of the motor 100.

The controller 400 may sense the phase voltage and the phase current of the motor 100 through the sensors 110 and 120. In this case, the phase voltage and the phase current (for example, Vu/Iu) sensed by the sensors 110 and 120 may be converted into digital signals through an AD converter 300 and input to the controller 400.

When a user drives an electronic apparatus in which the motor 100 is mounted, for example, an appliance, the controller 400 may generate a PWM signal according to a target speed (in FIG. 3, Target speed) set by a user's command.

In other words, when the user sets a driving stage number (operation level) of the electronic apparatus or an upper-level control stage automatically sets a driving stage number and the electronic apparatus is driven, the controller 400 may generate a PWM signal according to a target speed corresponding to the operation level. The controller 400 may transfer the PWM signal to the inverter 200. Here, the appliance may be a washing machine, a drying machine, or the like including the BLDC motor 100.

In the embodiment, the controller 400 may calculate a zero cross delay value of a phase current in contrast to a phase of a phase voltage using a phase of the phase voltage and a zero cross point of the phase current sensed by the sensors 110 and 120. Here, the controller 400 may calculate the zero cross delay value of the phase current using the phase of the phase voltage and the zero cross point of the phase current when a real speed of the motor 100 reaches the target speed.

The controller 400 may determine an amount of load applied to the motor 100 using the zero cross delay value and a duty ratio of the PWM signal. The controller 400 may have a configuration as in FIG. 3.

Referring to FIG. 3, the controller 400 may include a proportional-integral (PI) controller 410, a PWM signal generator 420, a detector 430, and a speed calculator 440.

The PI controller 410 may check a difference (error) between the target speed Target speed and a real speed Real speed, and may generate a motor speed adjustment value for adjusting a motor speed such that the target speed and the real speed are the same.

The PI controller 410 may generate a lead angle adjustment value for making a phase of the back electromotive force detected by the detector 430 described below and a phase of the phase current the same.

The PI controller 410 may generate a PI control value including the motor speed adjustment value and the lead angle adjustment value and transmit the PI control value to the PWM signal generator 420.

The PWM signal generator 420 may determine a PWM duty ratio according to the PI control value and generate a PWM signal having the PWM duty ratio.

The PWM signal generator 420 checks a current speed of the motor and a position of the rotor on the basis of a back electromotive force measured by floating at a zero current point of the phase voltage of the motor and increases the speed of the motor.

The PWM signal generator 420 determines whether a pulse width modulation duty of the motor is a maximum.

The PWM signal generator 420 increases the speed by increasing the pulse width modulation duty and frequency of the motor.

The detector 400 may detect a back electromotive force of a certain coil generated in the motor 100.

The detector 400 may detect a zero cross point of the phase current. Here, the zero cross point may mean a point at which a phase current of a certain coil is zero as in FIG. 5 or 6. The back electromotive force may be detected at the zero cross point of the phase current in a state in which the certain coil is floated.

The detector 400 measures a back electromotive force by floating the phase voltage of the motor when the speed of the motor is equal to or higher than a set speed. Here, the set speed is not limited to a certain speed.

The detector 400 determines whether the zero cross point of the back electromotive force coincides with the zero current point of the phase current of the motor.

The detector 400 determines whether a speed command of the motor is changed or whether a difference between a point at which a phase angle of the phase voltage of the motor is 0° and the zero current point of the phase current of the motor is equal to or greater than a set value. This is because determination is made that a load is changed or there is an influence of external factors.

The detector 400 decreases an error between the zero cross point of the back electromotive force and the zero current point of the phase current of the motor through a phase lead operation in a voltage cycle on the basis of a lead angle of the motor when the pulse width modulation duty of the motor is a maximum.

The detector 400 measures the back electromotive force by floating at the zero current point of the phase voltage of the motor when the speed command of the motor is changed or when the difference between the point at which the phase angle of the phase voltage of the motor is 0° and the zero current point of the phase current of the motor is equal to or greater than the set value. Floating at the zero current point of the phase voltage of the motor minimizes the torque ripple of the motor.

The speed calculator 440 may calculate the real speed of the motor 100 using the back electromotive force. Here, the back electromotive force and the real speed of the motor 100 may be in a proportional relationship.

The speed calculator 440 drives the motor through open loop control and determines whether the speed of the motor is equal to or higher than the set speed. Here, the set speed is not limited to a certain speed.

The speed calculator 440 closes the floating of the phase voltage of the motor and drives the motor when the zero cross point of the back electromotive force coincides with the zero current point of the phase current of the motor.

When the zero cross point of the back electromotive force do not coincide with the zero current point of the phase current of the motor, the speed calculator 440 increases the speed of the motor, and then, the detector measures the back electromotive force by floating the phase voltage of the motor.

Referring to FIG. 4, the detector 400 may include a phase voltage floating part 431, a back electromotive force measurement part 432, a back electromotive force range determination part 433, a back electromotive force calculation part 434, and a floating release part 435.

The phase voltage floating part 431 floats a phase voltage of the motor.

The back electromotive force measurement part 432 measures a back electromotive force corresponding to a pulse signal generated by floating the phase voltage.

When the back electromotive force is not outside a set range, the back electromotive force measurement part 432 measures the back electromotive force corresponding to the pulse signal generated by floating the phase voltage.

When the back electromotive force is not maintained within the set range, the back electromotive force measurement part 432 measures the back electromotive force corresponding to the pulse signal generated by floating the phase voltage.

The back electromotive force range determination part 433 determines whether the back electromotive force is within the set range. This is to determine whether the back electromotive force is a back electromotive force during a floating interval, and when the back electromotive force is outside the set range, to prevent determination to be a back electromotive force. Here, the set range is 0 + N to VDD - N (where VDD is a motor driving voltage, and N is a set value), and is not limited to a certain range. That is, only when the measured back electromotive force is within a range of 0 to the set value on the basis of VDD/2 that is a value half the motor driving voltage, determination is made to be a back electromotive force.

The back electromotive force range determination part 433 determines whether the back electromotive force is consecutively maintained within the set range for a set number of pulse signals generated by the motor during the floating interval when the back electromotive force is within the set range. This is to determine whether the back electromotive force is stably maintained within the set range.

The back electromotive force range determination part 433 determines whether the back electromotive force is outside the set range for all of the set number of the pulse signals during the floating interval when the back electromotive force is not within the set range. This is to prevent determination to be a back electromotive force when the back electromotive force is outside the set range.

When the back electromotive force is consecutively maintained within the set range for the set number of pulse signals, the back electromotive force calculation part 434 calculates an average value from the back electromotive force for each of the set number of pulse signals and determines the average value as the back electromotive force during the floating interval. The reason that the average value is calculated and determined as the back electromotive force is to obtain a representative value of the back electromotive force because the back electromotive force may be different for each pulse signal.

The back electromotive force calculation part 434 does not determine a back electromotive force in a corresponding cycle of the phase voltage when the back electromotive force is outside the set range for all of the set number of pulse signals during the floating interval.

After the average value is calculated from the back electromotive force for each of the set number of pulse signals and determined as the back electromotive force during the floating interval, the floating release part 435 releases the floating of the phase voltage of the motor. The reason is because a back electromotive force does not need to be measured after the back electromotive force is determined.

The floating release part 435 releases the floating of the phase voltage of the motor when the back electromotive force measurement part does not measure the back electromotive force corresponding to the pulse signal generated by floating the phase voltage. The reason is because a back electromotive force does not need to be measured after a back electromotive force is not determined.

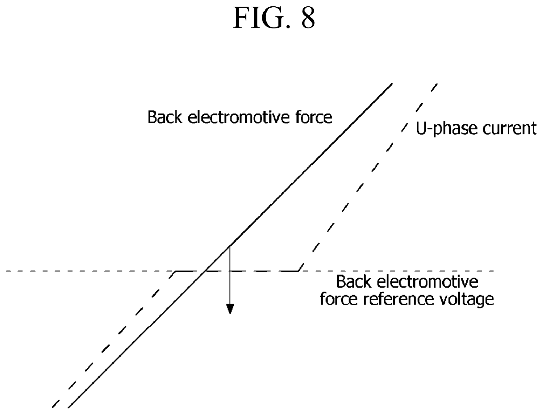

FIG. 7 is a graph illustrating a floating region for back electromotive force measurement according to the embodiment of the present disclosure, and FIG. 8 is a graph illustrating a back electromotive force and a U-phase current with respect to a back electromotive force reference voltage according to the embodiment of the present disclosure.

Referring to FIG. 7, it can be understood that the pulse signal is generated according to the operation of the motor, and the floating region is present by floating. In this case, a back electromotive force is measured at a point at which floating is started. When the back electromotive force is greater than the reference voltage, the back electromotive force is not determined and the floating interval is maintained, and when the back electromotive force is within the set range, a back electromotive force is accumulated.

After the back electromotive force during the floating interval is determined, the floating interval is released.

Referring to FIG. 8, while the back electromotive force continuously increases after floating starts, and the U-phase current (see FIGS. 1 to 3) increases along with the back electromotive force, an interval where the U-phase current does not increase or decrease is formed.

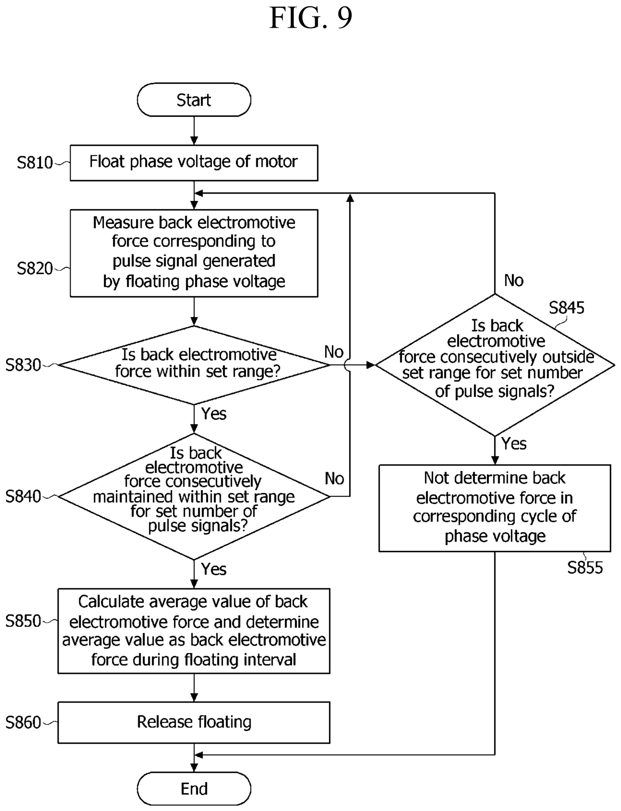

FIG. 9 is a flowchart illustrating a method for measuring a back electromotive force of a motor according to the embodiment of the present disclosure.

Referring to FIG. 9, the method for measuring a back electromotive force of a motor may include S810 to S860.

First, the phase voltage floating part 431 floats the phase voltage of the motor (S810).

After S810, the back electromotive force measurement part 432 measures the back electromotive force corresponding to the pulse signal generated by floating the phase voltage (S820).

After S820, the back electromotive force range determination part 433 determines whether the back electromotive force is within the set range (S830). This is to determine whether the back electromotive force is a back electromotive force during a floating interval, and when the back electromotive force is outside the set range, to prevent determination to be a back electromotive force. Here, the set range is 0 + N to VDD - N (where VDD is a motor driving voltage, and N is a set value), and is not limited to a certain range. That is, only when the measured back electromotive force is within a range of 0 to the set value on the basis of VDD/2 that is a value half the motor driving voltage, determination is made to be a back electromotive force.

When the condition of S830 is satisfied, the back electromotive force range determination part 433 determines whether the back electromotive force is consecutively maintained within the set range for the set number of pulse signals generated by the motor during the floating interval (S840). This is to determine whether the back electromotive force can be stably maintained within the set range.

When the condition of S840 is satisfied, the back electromotive force calculation part 434 calculates the average value from the back electromotive force for each of the set number of pulse signals and determines the average value as the back electromotive force floating interval (S850). The reason that the average value is calculated and determined as the back electromotive force is to obtain a representative value of the back electromotive force because the back electromotive force may be different for each pulse signal.

After S850, the floating release part 435 releases the floating of the phase voltage of the motor (S860). The reason is because a back electromotive force does not need to be measured after the back electromotive force is determined.

When the condition of S840 is not satisfied, the back electromotive force measurement part 432 measures the back electromotive force corresponding to the pulse signal generated by floating the phase voltage (S820).

On the other hand, when the condition of S830 is not satisfied, the back electromotive force range determination part 433 determines whether the back electromotive force is outside the set range for all of the set number of pulse signals during the floating interval (S845). This is to prevent determination to be a back electromotive force when the back electromotive force is outside the set range.

When the condition of S845 is satisfied, the back electromotive force calculation part 434 does not determine a back electromotive force in the corresponding cycle of the phase voltage (S855).

After S855, the floating release part 435 releases the floating of the phase voltage of the motor (S860). The reason is because a back electromotive force does not need to be measured after a back electromotive force is not determined.

When the condition of S845 is not satisfied, the back electromotive force measurement part 432 measures the back electromotive force corresponding to the pulse signal generated by floating the phase voltage (S820).

While the present disclosure described above has been described with reference to the embodiment of the present disclosure illustrated in the accompanying drawings to help with the understanding of the present disclosure, this should be considered in a descriptive sense only, and it will be understood by those skilled in the art that various modifications and other equivalent embodiments may be made. Therefore, the scope of the present disclosure is defined by the appended claims.

## Claims

1. A device for measuring a back electromotive force of a motor, the device comprising:
a phase voltage floating part configured to float a phase voltage of the motor;
a back electromotive force measurement part configured to measure a back electromotive force corresponding to a pulse signal generated by floating the phase voltage;
a back electromotive force range determination part configured to determine whether the back electromotive force is within a set range, and when the back electromotive force is within the set range, to determine whether the back electromotive force is consecutively maintained within the set range for a set number of pulse signals generated by the motor during a floating interval; and
a back electromotive force calculation part configured to calculate an average value from a back electromotive force for each of the set number of pulse signals, and to determine the average value as a back electromotive force during the floating interval when the back electromotive force is consecutively maintained within the set range for the set number of pulse signals.

2. The device for measuring a back electromotive force of a motor according to claim 1, the device further comprising:
a floating release part configured to release the floating of the phase voltage of the motor after the average value is calculated from the back electromotive force for each of the set number of pulse signals and determined as the back electromotive force during the floating interval.

3. The device for measuring a back electromotive force of a motor according to claim 1 or 2,
wherein the back electromotive force range determination part determines whether the back electromotive force is outside the set range for all of the set number of pulse signals during the floating interval when the back electromotive force is not within the set range, and
the back electromotive force calculation part does not determine a back electromotive force in a corresponding cycle of the phase voltage when the back electromotive force is outside the set range for all of the set number of pulse signals during the floating interval.

4. The device for measuring a back electromotive force of a motor according to claim 3, wherein the back electromotive force measurement part measures the back electromotive force corresponding to the pulse signal generated by floating the phase voltage when the back electromotive force is not outside the set range.

5. The device for measuring a back electromotive force of a motor according to any one of the preceding claims, wherein the back electromotive force measurement part measures the back electromotive force corresponding to the pulse signal generated by floating the phase voltage when the back electromotive force is not maintained within the set range.

6. The device for measuring a back electromotive force of a motor according to any one of the preceding claims, wherein the set range is 0 + N to VDD - N (where VDD is a motor driving voltage, and N is a set value).

7. A method for measuring a back electromotive force of a motor, the method comprising:
by a phase voltage floating part, floating a phase voltage of the motor;
by a back electromotive force measurement part, measuring a back electromotive force corresponding to a pulse signal generated by floating the phase voltage;
by a back electromotive force range determination part, determining whether the back electromotive force is within a set range;
by the back electromotive force range determination part, determining whether the back electromotive force is consecutively maintained within the set range for a set number of pulse signals generated by the motor during a floating interval when the back electromotive force is within the set range; and
by a back electromotive force calculation part, calculating an average value from a back electromotive force for each of the set number of pulse signals and determining the average value as a back electromotive force during the floating interval when the back electromotive force is consecutively maintained within the set range for the set number of pulse signals.

8. The method for measuring a back electromotive force of a motor according to claim 7, the method further comprising:
by a floating release part, releasing the floating of the phase voltage of the motor after the average value is calculated from the back electromotive force for each of the set number of pulse signals and determined as the back electromotive force during the floating interval.

9. The method for measuring a back electromotive force of a motor according to claim 7 or 8, the method further comprising:
determining whether the back electromotive force is outside the set range for all of the set number of pulse signals during the floating interval when the back electromotive force is not within the set range, by the back electromotive force range determination part; and
by the back electromotive force calculation part, not determining a back electromotive force in a corresponding cycle of the phase voltage when the back electromotive force is outside the set range.

10. The method for measuring a back electromotive force of a motor according to claim 9, the method further comprising:
by the back electromotive force measurement part, measuring the back electromotive force corresponding to the pulse signal generated by floating the phase voltage when the back electromotive force is not outside the set range.

11. The method for measuring a back electromotive force of a motor according to any one of claims 7 to 10, the method further comprising:
by the back electromotive force measurement part, measuring the back electromotive force corresponding to the pulse signal generated by floating the phase voltage when the back electromotive force is not maintained within the set range.

12. The method for measuring a back electromotive force of a motor according to any one of claims 7 to 11, wherein the set range is 0 + N to VDD - N (where VDD is a motor driving voltage, and N is a set value).
